# DEMANDE DE BREVET EUROPEEN

(11) **EP 0 593 319 A1**
(43) Date de publication de la demande: **20.04.1994**
(21) Numéro de dépôt: 93402000.9
(22) Date de dépôt: 03.08.1993
(51) Int. Cl.: G11C 7/00

(54) **Circuit intégré de mémoire avec protection contre des perturbations**

(30) Priorité: 13.08.1992 FR 9210000
(71) Demandeur: THOMSON-CSF, 75008 Paris (FR)
(72) Inventeur: Ferrant, Richard, F-92402 Courbevoie Cédex (FR); Fel, Bruno, F-92402 Courbevoie Cédex (FR)
(74) Mandataire: Guérin, Michel

(57) **Abrégé**

L'invention concerne une mémoire en circuit intégré comportant au moins une colonne de cellules de mémoire (MC) montées en parallèle les unes avec les autres et connectées à au moins une ligne de bit (BL1, BL2), chaque cellule de mémoire (MC) étant rellée à une ligne de bit par au moins un transistor d'accès (T1, T2), caractérisée en ce qu'elle contient un transistor de protection (T3) connecté à la ligne de bit, et commandé de manière à être rendu conducteur de façon à limiter, lors des phases de lecture de la mémoire, la chute de tension sur la ligne de bit lorsque cette chute dépasse un seuil dont la valeur est inférieure à une valeur provoquant l'écriture d'une information dans une cellule de mémoire.

## Description

La présente invention concerne une mémoire en circuit intégré contenant un dispositif permettant d'améliorer la tenue de la mémoire face à différents phénomènes générateurs de courants de fuite et susceptibles de modifier les informations stockées.

De façon générale, une mémoire comprend un réseau de cellules de mémoire agencées en lignes et en colonnes. Les cellules d'une même ligne sont reliées à une même ligne de mot et les cellules d'une même colonne à une même ligne de bit qui permet de lire ou d'écrire une information dans la cellule située au croisement de cette ligne de bit et de la ligne de mot sélectionnée.

Pour certains types de mémoires, les mémoires statiques notamment (SRAM), l'accès à chaque cellule de mémoire se fait par l'intermédiaire de transistors, par exemple des transistors MOSFET de type N. En fonctionnement normal, ces transistors sont passants ou bloqués selon que la cellule est sélectionnée ou non. Sous l'effet de différentes perturbations (bruit sur les tensions d'alimentation, création de paires électron-trou par impact d'ions lourds sur les lignes de bit, irradiations) des transistors normalement bloqués peuvent se mettre à conduire. Lors des phases de lecture, ces perturbations peuvent placer les cellules de mémoire dans des conditions voisines des conditions d'écriture. L'état de la cellule peut alors s'inverser et l'information stockée n'est alors plus l'information correcte. Ceci peut se produire surtout si un grand nombre de cellules d'une colonne sont dans un état donné et si la cellule lue est justement dans l'état inverse ; en effet, dans ce cas, les courants de fuite des transistors d'accès aux cellules non sélectionnées se cumulent et modifient les potentiels des lignes de bit dans un sens tendant à inverser l'état de la cellule sélectionnée.

Afin de pallier cet inconvénient, il est connu de l'homme de l'art de limiter le nombre de cellules de mémoire par colonne, ce qui a pour effet de limiter le courant de fuite. Certaines mémoires ne contiennent alors, par exemple, que 64 cellules de mémoire par colonne.

Ceci représente un inconvénient car cela multiplie le nombre de colonnes dont les commandes sont indépendantes les unes des autres, et cela limite les capacités de stockage des mémoires qui doivent être protégées contre ces risques de perturbation de l'information stockée.

L'invention ne présente pas cet inconvénient.

La présente invention a pour objet une mémoire en circuit intégré comportant au moins une colonne de cellules de mémoire connectées en parallèle à au moins une ligne de bit, avec au moins un transistor d'accès respectif pour relier chaque cellule de mémoire à la ligne de bit, caractérisée en ce qu'elle comporte un transistor de protection connecté à la ligne de bit et commandé de manière à être rendu conducteur lorsque cette chute de tension dépasse un seuil dont la valeur est inférieure à une valeur provoquant l'écriture d'une information dans une cellule de mémoire et à limiter la chute de tension sur la ligne de bit lors des phases de lecture de la mémoire.

Dans le cas des mémoires statiques notamment, on aura deux lignes de bit complémentaires pour chaque colonne, avec un transistor d'accès à une cellule pour chaque ligne de bit, c'est-à-dire deux transistors d'accès par cellule; le transistor de protection sera placé entre les deux lignes de bit complémentaires et la chute de tension qu'on cherchera à limiter se traduira par un écart de tension entre les deux lignes de bit complémentaires.

De préférence, la conduction du transistor sera totalement inhibée pendant les phases d'écriture d'informations dans les cellules de la colonne, afin que la présence du transistor de protection ne perturbe pas l'écriture par un conflit de forces.

Le transistor de protection sera de préférence à canal N, avec une tension de seuil de l'ordre du volt.

Un avantage de l'invention est qu'on repousse la limite maximale du nombre de cellules de mémoire qu'on peut connecter à une même colonne tout en conservant une bonne fiabilité de l'information stockée même en présence de perturbations sévéres.

L'invention s'applique tout particulièrement aux mémoires statiques dans lesquelles chaque cellule est constituée par une bascule bistable connectée par deux transistors d'accès respectifs à deux lignes de bit complémentaires.

Un avantage de l'invention est qu'on repousse la limite maximale du nombre de cellules de mémoire d'une même colonne.

D'autres caractéristiques et avantages de l'invention apparaîtront à la lecture d'un mode de réalisation préférentiel fait avec référence aux figures ci-annexées dans lesquelles :
- la figure 1 représente l'architecture d'une mémoire classique selon l'art antérieur.
- la figure 2 représente une partie détaillée de l'architecture décrite en figure 1.
- la figure 3 représente l'architecture d'une mémoire selon le mode de réalisation préférentiel de l'invention.

Sur toutes les figures, les mêmes repères désignent les mêmes éléments. L'invention sera décrite à propos de mémoires statiques, pour lesquelles elle est la plus intéressante.

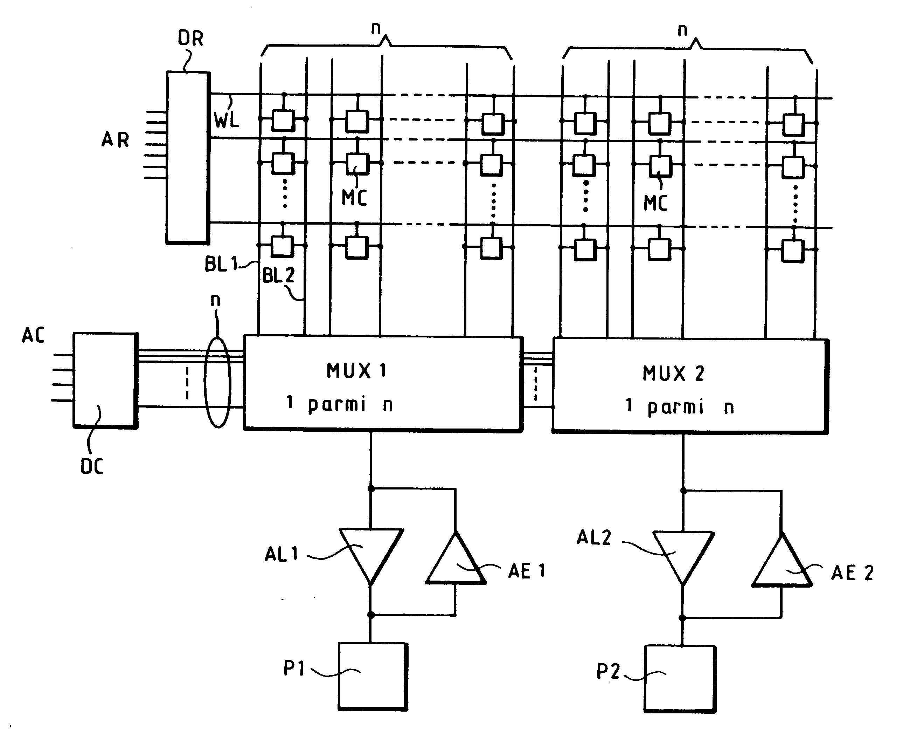

La figure 1 représente l'architecture d'une mémoire classique selon l'art antérieur.

Cette mémoire comprend un réseau de cellules de mémoire MC agencées en lignes et en colonnes.

Les cellules d'une même ligne sont reliées à une même ligne de mot WL issue d'un décodeur de rangée DR qui permet de désigner une ligne parmi N en fonction d'une adresse de ligne AR. Les cellules d'une même colonne sont reliées à deux lignes de bit complémentaires BL1 et BL2. Le choix d'une ligne de mot WL et d'un ensemble de deux lignes de bit BL1 et BL2 permet de sélectionner une cellule de mémoire en écriture ou en lecture.

Dans le cas général, le nombre de colonnes de la mémoire est un multiple du nombre de plots d'entrée/sortie de données de la mémoire. Un décodeur de colonne DC reçoit une adresse de colonne AC et commande un multiplexeur. Les colonnes sont alors associées par groupes de n colonnes. Ces groupes sont juxtaposés ou imbriqués les uns dans les autres. Le multiplexeur permet de sélectionner une ligne de bit parmi n, ceci dans chaque groupe, et de la connecter à un amplificateur de lecture et à un amplificateur d'écriture, ces derniers étant reliés à un plot de données. Sur la figure 1 sont représentés deux groupes de n colonnes avec respectivement deux multiplexeurs MUX 1 et MUX 2, commandés simultanément par le décodeur DC, deux amplificateurs de lecture AL1 et AL2, deux amplificateurs d'écriture AE1 et AE2, ainsi que deux plots de données P1 et P2.

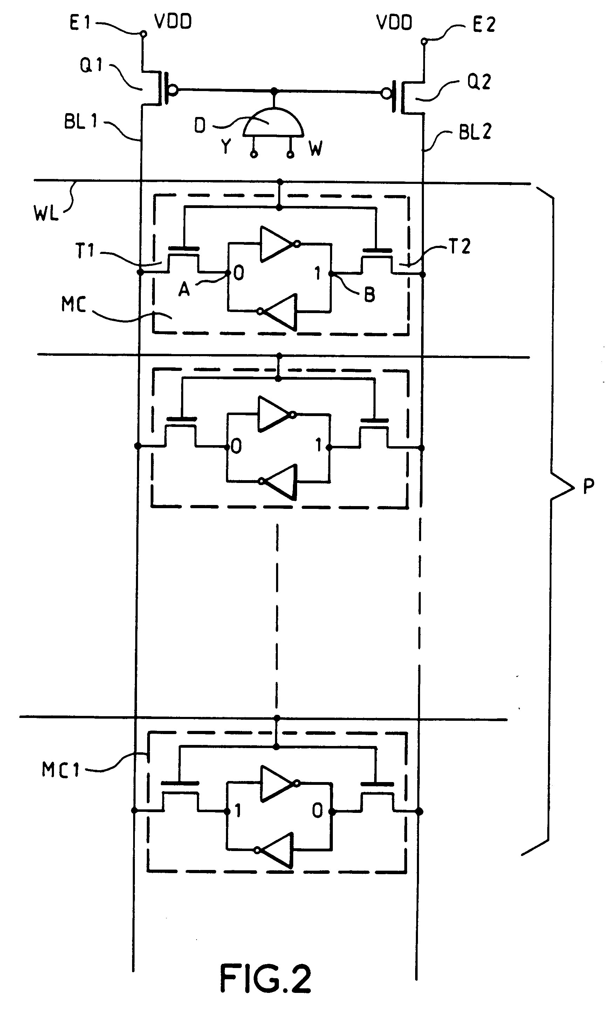

La figure 2 représente une partie détaillée de l'architecture décrite en figure 1.

Sur cette figure sont détaillées les cellules de mémoire MC qui sont comprises dans une même colonne entre deux lignes de bit BL1 et BL2. Chaque cellule MC est constituée d'une bascule bistable symbollsée ici par deux inverseurs rebouclés l'un sur l'autre. Les deux inverseurs constituent donc un sous-ensemble compris entre deux points A et B. Le point A est relié à la source d'un premier transistor d'accès qui est un transistor MOS de type N, T1, dont le drain est relié à la ligne de bit BL1. Le point B est relié à la source d'un second transistor d'accès qui est un transistor MOS de type N, T2, dont le drain est reliée à la ligne de bit BL2. Les grilles de chacun des deux transistors T1 et T2 sont reliées entre elles et à une même ligne de bit WL.

Les transistors d'accès T1 et T2 sont passants quand on désire écrire une information dans la cellule de mémoire MC (en A et B) ou quand on désire lire l'information écrite dans ladite cellule.

Les lignes de bit BL1 et BL2 sont reliées, à leurs extrémités respectives E1 et E2, à la tension d'alimentation VDD, par l'intermédiaire de transistors de charge Q1, Q2, ici des transistors à canal P qui sont conducteurs pendant les phases de lecture de la mémoire et qui se comportent alors comme des résistances de pull up. Ces transistors sont représentés avec leur circuit de commande qui peut être une porte ET, notée D sur la figure, recevant d'une part un signal d'écriture W et d'autre part un signal de sélection de colonne Y ; les transistors Q1 et Q2 sont bloqués uniquement lors de l'écriture d'informations dans la colonne correspondante.

Chaque colonne contient, par exemple, P cellules de mémoire. Pour expliquer l'invention, on va supposer que toutes les cellules sauf une sont dans le même état soit, par exemple, O en A et 1 en B et une seule cellule MC1 est dans l'état inverse, soit, selon ce même exemple, 1 en A et O en B. Ce cas est choisi car il réalise les conditions les plus défavorables dans lesquelles peuvent être mises les mémoires dans le cas où se produisent les perturbations mentionnées précédemment.

Lorsqu'on effectue la lecture de la cellule de mémoire MC1 qui est dans l'état inverse des autres (1 en A et O en B) les transistors T1 et T2 de cette cellule sont passants et les transistors T1 et T2 des autres cellules sont bloqués.

Sous l'effet de l'une quelconque des perturbations mentionnées précédemment (création de paires électron-trou par impact d'ions lourds sur les lignes de bit, irradiation, etc...) les transistors T1 restent logiquement bloqués mais présentent un courant de fuite lié à la perturbation. Le potentiel de la ligne de bit BL1 ne peut alors plus être maintenu à la tension d'alimentation VDD. Il peut alors apparaître une tension différentielle suffisante entre les deux lignes de bit pour inverser l'état de la cellule MC1 qui est en lecture et dont les transistors d'accès sont par conséquent passants. Le potentiel de la ligne de bit BL1 diminue d'autant plus que le courant de fuite est important, et donc que le nombre de transistors est important. C'est pour cette raison que, selon l'art antérieur, le nombre de cellules par colonne est limité, par exemple, à 64.

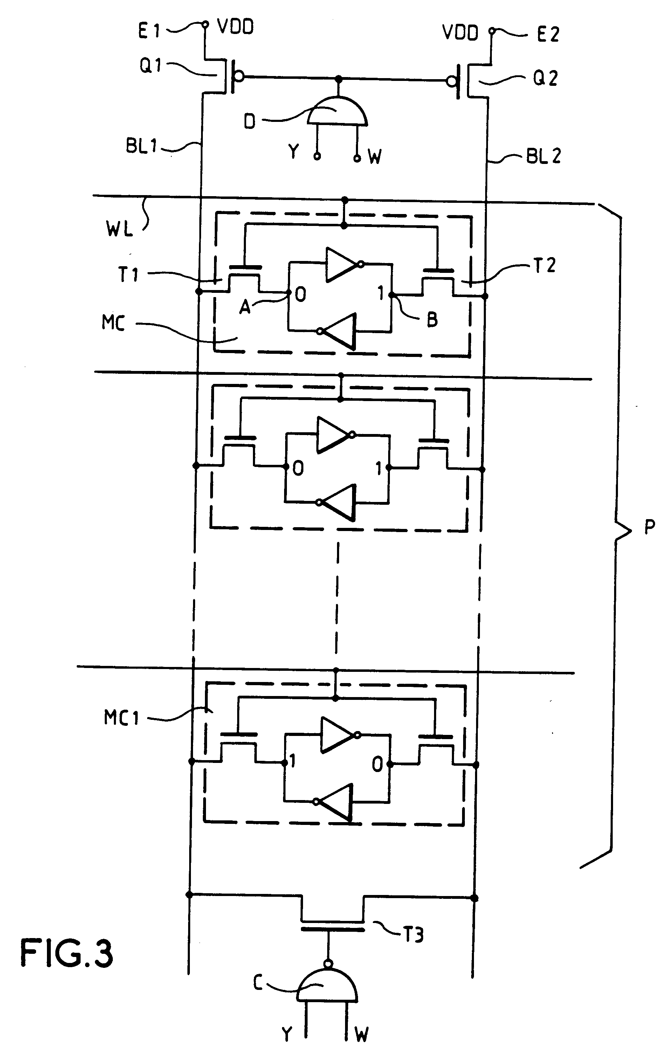

La figure 3 représente l'architecture d'une mémoire selon le mode de réalisation préférentiel de l'invention.

Sur cette figure n'est représentée qu'une colonne de cellules de mémoire entre deux lignes de bit, à l'image de ce qui a été décrit en figure 2. Il est évident que dans une mémoire complète, l'invention concerne chacune des colonnes de cellules de mémoire contenues entre deux lignes de bit.

Le dispositif selon l'invention est constitué d'un transistor de protection T3 dont le drain est relié à la ligne de bit BL1 et la source à la ligne de bit BL2. Dans l'exemple représenté, la grille de ce transistor est rellée à la sortie d'un circuit "NON ET", C, dont les deux entrées sont reliées l'une à une commande d'écriture W et l'autre à une commande Y de sélection de la colonne considérée. Le transistor T3 est, de préférence, un transistor MOS de type N similaire aux autres transistors à canal N de la mémoire.

Durant les phases de lecture, la grille du transistor T3 est portée à un potentiel voisin de l'alimentation VDD. Il en résulte que le transistor devient conducteur dès que la tension sur l'une des lignes de bit descend au-dessous d'une valeur égale à VDD moins VT où VT est la tension de seuil du transistor T3. Cette tension est classiquement de l'ordre de 1 Volt. Par conséquent, même si on se place dans le cas le plus défavorable mentionné plus haut (toutes les cellules dans l'état inverse de la cellule MC1 qu'on est train de lire), l'écart de tension entre les lignes BL1 et BL2 ne peut pas dépasser le seuil VT et cette tension est insuffisante pour faire basculer l'état de la cellule MC1. En régime normal (sans perturbations), le transistor T3 ne perturbe pas la lecture car il suffit d'un écart de quelques dizaines de millivolts entre les lignes BL1 et BL2 pour détecter l'état d'une cellule.

De préférence, le transistor T3 est bloqué lors de l'écriture de données dans l'une quelconque des cellules de mémoire de la colonne. C'est là le rôle du circuit C. La commande de la grille du transistor T3 est en effet au niveau 0 puisque les commandes d'écriture et de décodage de la colonne sont au niveau 1. On pourrait prévoir aussi que le transistor T3 soit bloqué par la commande W seulement, c'est-à-dire simultanément pour toutes les colonnes pendant les phases d'écriture.

Dans tous les autres cas, tels la lecture ou la position dite de "stand-by", le transistor T3 est activé car sa tension de grille est au niveau 1. Selon l'invention, le transistor T3 est choisi de façon, d'une part, à permettre l'évacuation des charges entre lignes de bit et, d'autre part, à empêcher que n'apparaisse entre lignes de bit une tension différentielle suffisante pour effacer la cellule qui est en lecture.

Un critère de choix du transistor T3 est sa tension de seuil VT ou tension grille/source au-dessus de laquelle il devient passant. Cette tension est choisie suffisamment basse de façon que ce même transistor conduise rapidement lors de la perturbation génératrice de courants de fuite. Par exemple, selon un mode de réalisation préférentiel de l'invention une tension VT de 800 millivolts est nécessaire pour assurer la conduction de T3 alors que 100 à 200 millivolts de tension différentielle entre lignes de bit sont suffisants pour lire une cellule.

Selon l'invention le transistor T3 a, de préférence, son substrat mis à la masse afin de diminuer les bruits parasites.

Comme cela a été mentionné précédemment, un avantage de l'invention est de ne pas limiter le nombre de cellules de mémoire dans une colonne.

Un autre avantage de l'invention est de ne pas être conditionné par une quelconque technologie.

On notera que la mise en oeuvre de l'invention n'augmente pas l'encombrement du circuit car, en pratique, le transistor T3 peut être situé sous les bus d'alimentation du circuit qui entourent en général tout le plan mémoire.

Un autre avantage de l'invention est donc sa facile mise en oeuvre.

## Revendications

1. Mémoire en circuit intégré comportant au moins une colonne de cellules de mémoire (MC) montées en parallèle les unes avec les autres et connectées à au moins une ligne de bit (BL1, BL2), chaque cellule de mémoire (MC) étant reliée à une ligne de bit par au moins un transistor d'accès (T1, T2), caractérisée en ce qu'elle contient un transistor de protection (T3) connecté à la ligne de bit, et commandé de manière à être rendu conducteur de façon à limiter, lors des phases de lecture de la mémoire, la chute de tension sur la ligne de bit lorsque cette chute dépasse un seuil dont la valeur est inférieure à une valeur provoquant l'écriture d'une information dans une cellule de mémoire.

2. Mémoire selon la revendication 1, caractérisée en ce que chaque colonne de cellules de mémoire (MC) est connectée à deux lignes de bit (BL1, BL2), chaque cellule de mémoire étant rellée à une ligne de bit par un transistor d'accès (T1, T2), et en ce que le transistor de protection (T3), monté en parallèle avec lesdites cellules de mémoire, relie les deux lignes de bit.

3. Mémoire selon la revendication 2, caractérisée en ce que le transistor de protection (T3) est un transistor MOS de type N qui relie les deux lignes de bit de façon que son drain soit relié à une première ligne de bit (BL1) et sa source à la deuxième ligne de bit (BL2).

4. Mémoire selon la revendication 3, caractérisée en ce que la grille du transistor de protection (T3) est reliée à un circuit de commande (C) permettant de bloquer ledit transistor lors de l'écriture dans les cellules de mémoire.

5. Mémoire selon la revendication 4, caractérisée en ce que le circuit de commande (C) est un circuit "NON ET" dont la sortie est reliée à la grille du transistor de protection (T3) et dont les deux entrées sont reliées l'une à la commande d'écriture (W) et l'autre à la commande (Y) de sélection de colonne.

6. Mémoire selon l'une quelconque des revendications 3 à 5, caractérisée en ce que le transistor de protection (T3) est câblé de façon à devenir conducteur dès que la tension entre son drain et sa source est égale à sa tension de seuil (VT).

7. Mémoire selon l'une quelconque des revendications précédentes, caractérisée en ce que le transistor de protection (T3) a son substrat relié à la masse de la mémoire.

8. Mémoire selon l'une quelconque des revendications précédentes, caractérisée en ce que les cellules de mémoire (MC) sont des bascules bistables.

9. Mémoire selon l'une quelconque des revendications précédentes, caractérisée en ce que les transistors d'accès (T1, T2) sont des transistors MOS de type N.
